# EUROPEAN PATENT APPLICATION

(11) **EP 4 780 162 A1**
(43) Date of publication of application: **22.07.2026**
(21) Application number: 25221976.1
(22) Date of filing: 09.12.2025
(51) Int. Cl.: H10D 30/47, H10D 62/10, H10D 62/852, H10D 62/854, H10D 64/01, H10D 64/00, H10D 64/27, H10D 30/01, H10D 62/17, H10D 64/23

(54) **HEMT COMPRISING THICKNESS- AND ALUMINUM-CONCENTRATION-MODULATED BARRIER LAYERS**

(30) Priority: 20.01.2025 KR 20250007940; 17.07.2025 KR 20250096776
(71) Applicant: Samsung Electronics Co., Ltd., Suwon-si, Gyeonggi-do 16677 (KR)
(72) Inventor: SHIN, Donggyu, Suwon-si (KR); KIM, Boram, Suwon-si (KR); KIM, Jongseob, Suwon-si (KR); KIM, Jin-Hwan, Suwon-si (KR); LEE, Sangjun, Suwon-si (KR); HWANG, In Jun, Suwon-si (KR)
(74) Representative: Marks & Clerk LLP

(57) **Abstract**

A precursor strip (1) having a rectangular shape for an annular gap gasket suitable for a fire protection collar.

## Description

### BACKGROUND

In modern society, semiconductor devices are closely related to our daily lives. In particular, the importance of power semiconductor devices used in various fields such as transportation such as electric vehicles, railways, and electric trams, renewable energy systems such as solar power generation and wind power generation, and mobile devices is gradually increasing.

Power semiconductor devices are semiconductor devices used to handle high voltage or high current, and perform functions such as power conversion and control in large power systems or high-power electronic devices.

### SUMMARY

The present disclosure relates to a semiconductor device.

The problem to be solved by the present disclosure is to provide a semiconductor device with improved electrical characteristics.

The objects of the present disclosure are not limited to those described above, and other technical objects not mentioned will be clearly understood by those skilled in the art from the following description.

Power semiconductor devices have the ability to handle high power and durability, allowing them to handle large amounts of current and withstand high voltages. For example, power semiconductor devices may handle voltages from hundreds to thousands of volts and currents from tens to thousands of amperes. Power semiconductor devices may improve the efficiency of electrical energy by minimizing power loss. In addition, power semiconductor devices may be operated stably even in environments such as high temperatures.

These power semiconductor devices may be classified by material, for example, there are SiC power semiconductor devices and GaN power semiconductor devices. By manufacturing power semiconductor devices using SiC or GaN instead of existing silicon wafers (Si wafers), the shortcomings of silicon, which has unstable characteristics at high temperatures, may be complemented.

SiC power semiconductor devices are resistant to high temperatures and have low power loss, making them suitable for electric vehicles and renewable energy systems. GaN power semiconductor devices are expensive but efficient in terms of speed, making them suitable for fast charging of mobile devices.

A semiconductor device according to an implementation comprises a substrate, a channel layer on the substrate, a first barrier layer on the channel layer, a second barrier layer on the first barrier layer, a third barrier layer on the second barrier layer and extending into a portion of the first barrier layer and a portion of the second barrier layer, a gate electrode on the third barrier layer and a source electrode and a drain electrode on respective sides of the gate electrode, wherein each of the source electrode and the drain electrode extends into a first portion of the third barrier layer and is connected to the second barrier layer, and wherein the second barrier layer is doped with silicon.

A semiconductor device according to an implementation comprises a substrate, a channel layer on the substrate, a first barrier layer on the channel layer, a second barrier layer on the first barrier layer, a third barrier layer on the second barrier layer and extending into a portion of the first barrier layer and a portion of the second barrier layer, a gate electrode on the third barrier layer and a source electrode and a drain electrode positioned on respective sides of the gate electrode, wherein each of the source electrode and the drain electrode extends into a portion of the third barrier layer and is connected to the second barrier layer, wherein the first, second, and third barrier layers include aluminum gallium nitride (AlGaN), and wherein a content of aluminum in the first barrier layer is greater than a content of aluminum in the third barrier layer.

A semiconductor device according to an implementation comprises, a substrate, a buffer layer on the substrate, a channel layer on the buffer layer, a first barrier layer on the channel layer, a second barrier layer on the first barrier layer, a third barrier layer on the second barrier layer, the third barrier layer have a first portion that extends into a portion of the first barrier layer and a portion of the second barrier layer, a gate electrode on the first portion of the third barrier layer, the gate electrode extending in a first direction parallel to a surface of the substrate, a gate semiconductor layer between the first to three barrier layers and the gate electrode, the gate semiconductor layer having the same width in a horizontal direction as the gate electrode, and the gate semiconductor layer extending in the first direction, a first protective layer covering the third barrier layer, the gate electrode, and the gate semiconductor layer and a source electrode and a drain electrode on respective sides of the gate electrode, the source electrode and the drain electrode extending into the first protective layer and a second portion of the third barrier layer, the source electrode and the drain electrode being connected to the second barrier layer, wherein the second barrier layer is doped with silicon.

A method for manufacturing a semiconductor device according to an implementation includes forming a channel layer on a substrate, forming a first barrier layer on the channel layer, forming a second barrier layer on the first barrier layer, a portion of the first barrier layer and the second barrier layer to expose a portion of the channel layer, forming a third barrier layer on the first barrier layer and the second barrier layer, forming a gate electrode on the third barrier layer, and forming a source electrode and a drain electrode on respective sides of the gate electrode, wherein the forming the third barrier layer may include the forming the third barrier layer to cover the exposed portion of the channel layer, and the forming the source electrode and the drain electrode may include forming a trench by etching a portion of the third barrier layer to expose a portion of the second barrier layer, and filling the inside of the trench with the source electrode or the drain electrode.

In the method for manufacturing the semiconductor device according to the implementation, in the forming the second barrier layer, the second barrier layer may be doped with silicon (Si).

In the method for manufacturing the semiconductor device according to the implementation, the doping concentration of silicon in the second barrier layer may be greater than or equal to 1.0×10¹⁷ cm⁻³ and less than or equal to 1.0×10²⁰ cm⁻³.

In the method for manufacturing the semiconductor device according to the implementation, the thickness of the first barrier layer and the second barrier layer may be thinner than the thickness of the third barrier layer.

In the method for manufacturing the semiconductor device according to the implementation, the first barrier layer, the second barrier layer, and the third barrier layer include AlGaN, and a content of aluminum in the first barrier layer may be greater than a content of aluminum in the third barrier layer.

In the method for manufacturing the semiconductor device according to the implementation, the content of aluminum in the first barrier layer may be greater than or equal to 10 at% and less than or equal to 30 at%.

In the method for manufacturing the semiconductor device according to the implementation, a two-dimensional electron gas is positioned inside the channel layer, the channel layer includes a first portion having an upper surface in contact with the third barrier layer and a second portion having an upper surface in contact with the first barrier layer, and the density of the two-dimensional electron gas positioned in the second portion may be greater than the density of the two-dimensional electron gas positioned in the first portion.

According to the implementation, the semiconductor device with improved electrical characteristics may be provided.

At least some of the above and other features of the invention are set out in the claims.

### BRIEF DESCRIPTION OF THE DRAWINGS

FIG. 1 is a plan view showing a semiconductor device according to an implementation.
FIG. 2 and FIG. 3 are cross-sectional views showing semiconductor devices according to implementations.
FIG. 4 is a cross-sectional view showing a semiconductor device according to an implementation.
FIG. 5 is a cross-sectional view showing a semiconductor device according to an implementation.
FIG. 6 is an enlarged cross-sectional view of area A of FIG. 5.
FIG. 7 is a cross-sectional view showing a semiconductor device according to an implementation.
FIG. 8 is a cross-sectional view showing a semiconductor device according to an implementation.
FIG. 9 is an enlarged cross-sectional view of area B of FIG. 8.
FIGS. 10 to 18 are cross-sectional views showing a manufacturing process of a semiconductor device according to an implementation in an example order of the process.

### DETAILED DESCRIPTION

Hereinafter, with reference to accompanying drawings, various implementations of the present disclosure will be described in detail so that a person of an ordinary skill can easily implement the present disclosure. The present disclosure may be implemented in many different forms and is not limited to the implementations described herein.

In order to clearly explain the present disclosure, parts that are not relevant to the description are omitted, and identical or similar components are assigned the same reference numerals throughout the specification.

In addition, the size and thickness of each component shown in the drawings are shown arbitrarily for convenience of explanation, so the present disclosure is not necessarily limited to what is shown. In the drawings, the thickness of layers, films, panels, portions, etc., are exaggerated for clarity.

And in the drawings, for convenience of explanation, the thicknesses of some layers and portions are exaggerated. It will be understood that when an element such as a layer, film, portion, or substrate is referred to as being "on" another element, it can be directly on the other element or intervening elements may also be present. In contrast, when an element is referred to as being "directly on" another element, there are no intervening elements present. In addition, being "on" or "above" a reference element means being positioned on or below the reference element, and does not necessarily mean being positioned "above" or "on" in a direction opposite to gravity.

In addition, unless explicitly described to the contrary, the word "comprise", and variations such as "comprises" or "comprising", will be understood to imply the inclusion of stated elements but not the exclusion of any other elements.

In addition, throughout the specification, when referring to "a plane view", it means that the target portion is viewed from above, and when referring to "a cross-section view", it means that a cross section of the target portion cut vertically is viewed from a side.

Additionally, throughout the specification, two directions parallel to and intersecting with the upper surface of the substrate are defined as a first direction D1 and a second direction D2, respectively, and the direction perpendicular to the upper surface of the substrate is described as a third direction D3. For example, the first direction D1 and the second direction D2 may be orthogonal to each other. It will be understood that these are example directions relative to a semiconductor device, and do not imply any particular orientation of that device.

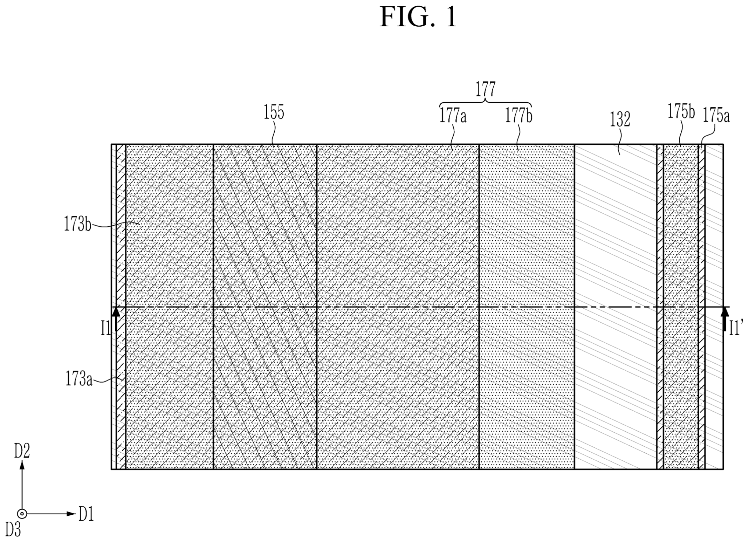

FIG. 1 is a plan view showing a semiconductor device according to one implementation. FIG.s 2 and 3 are cross-sectional views taken along line I1-I1' of FIG. 1.

For a clear understanding and simple illustration, FIG. 1 mainly illustrates the channel layer 132, the gate electrode 155, the source electrode 173, the drain electrode 175, and the field dispersion layer 177.

Referring to FIG. 1 to FIG. 3, a semiconductor device according to an implementation may include a substrate 110, a channel layer 132 positioned on the substrate 110, a plurality of barrier layers 136a, 136b, 136c positioned on the channel layer 132, a gate electrode 155 positioned on the barrier layer 136, a source electrode 173 and a drain electrode 175 positioned on both sides of the gate electrode 155.

The channel layer 132 is a layer that forms a channel between the source electrode 173 and the drain electrode 175, and a two-dimensional electron gas (2DEG) 134 may be located inside the channel layer 132. The two-dimensional electron gas 134 refers to a group of electrons that, in a charge transport model used in solid-state physics, may move freely in two dimensions (e.g., in a D1-D2 planar direction) but are tightly confined within the two-dimensional plane, such that movement in a third direction (e.g., in a D3 direction) is restricted. That is, the two-dimensional electron gas 134 may exist in the form of a two-dimensional sheet within a three-dimensional space. Such a two-dimensional electron gas 134 typically appears in semiconductor heterojunction structures, and in the semiconductor device according to the implementation, may be generated at an interface between the channel layer 132 and the barrier layer 136. For example, a two-dimensional electron gas 134 may be generated in the portion closest to the barrier layer 136 within the channel layer 132.

In an implementation, the density of the two-dimensional electron gas 134 may not be constant across the entire area of the channel layer 132. This will be discussed later. In the present disclosure, for convenience of explanation, the two-dimensional electron gas 134 is illustrated in the drawings as a set of '-' shaped symbols. In the present disclosure, the density of the two-dimensional electron gas 134 is represented such that a higher density is illustrated with thicker and longer '-' shapes, while a lower density is illustrated with thinner and shorter '-' shapes.

The channel layer 132 may include a nitride including group III-V materials, for example, Al, Ga, In, B, or a combination thereof. The channel layer 132 may be composed of a single layer or multiple layers. For example, the channel layer 132 may include AlₓIn_{y}Ga_{1-x-y}N (0 ≤ x ≤ 1, 0 ≤ y ≤ 1, x y ≤ 1), and for example, the channel layer 132 may include AIN, GaN, InN, InGaN, AlGaN, AllnN, AllnGaN, or a combination thereof. The channel layer 132 may be a layer doped with impurities or may be a layer that is not doped with impurities. The thickness of the channel layer 132 may be less than about several hundred nm.

The channel layer 132 may be positioned on the substrate 110, and a seed layer 115 or a buffer layer 120 may be positioned between the substrate 110 and the channel layer 132. The substrate 110, seed layer 115, or buffer layer 120 are layers necessary for forming the channel layer 132, and may be omitted in some cases. For example, when a substrate made of GaN is used as the channel layer 132, at least one of the substrate 110, the seed layer 115, or the buffer layer 120 may be omitted. Considering that a substrate made of GaN is relatively expensive, a channel layer 132 including GaN may be grown using a substrate 110 made of Si. At this time, since the lattice structure of Si and the lattice structure of GaN are different, it may not be easy to grow the channel layer 132 directly on top of the substrate 110. Accordingly, a seed layer 115 and a buffer layer 120 may be grown first on a substrate 110, and then a channel layer 132 may be grown on the buffer layer 120. Additionally, at least one of the substrate 110, the seed layer 115, or the buffer layer 120 may be removed from the final structure of the semiconductor device after being used in the manufacturing process.

The substrate 110 may include a semiconductor material. For example, the substrate 110 may include sapphire, Si, SiC, AIN, GaN, diamond, glass, or a combination thereof. The substrate 110 may be a SOI (Silicon on Insulator) substrate. However, the material of the substrate 110 is not limited to this, and all commonly used substrates may be applied. In some cases, the substrate 110 may include an insulating material. For example, several layers including a channel layer 132 may be first formed on a semiconductor substrate, and then the semiconductor substrate may be removed and replaced with an insulating substrate.

The seed layer 115 may be located on the substrate 110. The seed layer 115 may be positioned directly on the substrate 110. However, it is not limited thereto, and another layer may be additionally positioned between the substrate 110 and the seed layer 115. The seed layer 115 is a layer that functions as a seed for growing the buffer layer 120, and may comprise a crystal lattice structure that initiates the growth of the buffer layer 120. For example, the seed layer 115 may include AIN, but is not limited to.

The buffer layer 120 may be located on the seed layer 115. The buffer layer 120 may be located directly on the seed layer 115. However, it is not limited to this, and another layer may be additionally positioned between the seed layer 115 and the buffer layer 120. The buffer layer 120 may be located between the seed layer 115 and the channel layer 132. The buffer layer 120 may include a nitride including group III-V materials, for example, Al, Ga, In, B, or a combination thereof. The buffer layer 120 may include AlₓIn_{y}Ga_{1-x-y}N (0 ≤ x ≤ 1, 0 ≤ y ≤ 1, x y ≤ 1), and for example, the buffer layer 120 may include AIN, GaN, InN, InGaN, AlGaN, AllnN, AllnGaN, or a combination thereof. The buffer layer 120 may be composed of a single layer or multiple layers. For example, the buffer layer 120 may include a superlattice layer and a high-resistance layer.

The superlattice layer may serve to alleviate a difference in lattice constant and thermal expansion coefficient between the substrate 110 and the channel layer 132, and thereby relieve tensile stress and compressive stress that may occur between the substrate 110 and the channel layer 132.

The high-resistivity layer may be located on the superlattice layer. For example, the high-resistivity layer may be located directly on the superlattice layer. However, it is not limited thereto, other layers may be located between the superlattice layer and the high-resistivity layer. The high-resistance layer may be located between the superlattice layer and the channel layer 132. The high-resistance layer may prevent degradation of the semiconductor device by blocking leakage current from flowing through the channel layer 132. The high resistance layer may prevent degradation of the semiconductor device by preventing leakage current from flowing through the channel layer 132. The high resistance layer may be made of a material with low conductivity so that the substrate 110 and the channel layer 132 may be electrically insulated.

For example, the high-resistance layer may have a resistance value of 1.0X10⁶ Ω·cm or greater. For example, the resistance value of the high-resistance layer may be 1.0X10¹⁰ Ω·cm or more. As another example, the resistance value of the high-resistance layer may be greater than or equal to 1.0X10¹² Ω·cm. Resistance values may be measured by forming a measuring electrode within a high-resistance layer and allowing current to flow.

The high-resistivity layer may include a nitride containing group III-V materials, such as Al, Ga, In, B, or combinations thereof. The high resistivity layer may include AlₓIn_{y}Ga_{1-x-y}N (0 ≤ x ≤ 1, 0 ≤ y ≤ 1, x y ≤ 1), and may include, for example, AIN, GaN, InN, InGaN, AlGaN, AllnN, AlInGaN, or a combination thereof. The high-resistance layer may be composed of a single layer or multiple layers.

The barrier layer 136 may be positioned on the channel layer 132. The barrier layer 136 may be positioned directly on the channel layer 132. However, it is not limited thereto, and another layer may be additionally positioned between the channel layer 132 and the barrier layer 136. The portion of the channel layer 132 overlapping the barrier layer 136 may serve as a drift region DTR. The drift region DTR may be located between the source electrode 173 and the drain electrode 175. When a potential difference occurs between the source electrode 173 and the drain electrode 175, carriers may move in the drift region DTR. The semiconductor device may be turned on/off depending on whether voltage is applied to the gate electrode 155 and the magnitude of the voltage applied to the gate electrode 155. When a voltage higher than the threshold voltage is applied to the gate electrode 155 and the semiconductor device is turned on, a channel may be created in the depletion region DPR. Accordingly, movement of carriers may occur in the drift region DTR. When a voltage lower than the threshold voltage is applied to the gate electrode 155 or no voltage is applied, the channel path in the depletion region DPR may be blocked and carrier movement may not occur.

The barrier layer 136 may include a nitride including group III-V materials, for example, Al, Ga, In, B, or a combination thereof. The barrier layer 136 may include AlₓIn_{y}Ga_{1-x-y}N (0 ≤ x ≤ 1, 0≤y≤1, x y ≤ 1), and for example, the barrier layer 136 may include GaN, InN, AlGaN, AllnN, InGaN, AIN, AllnGaN, or a combination thereof. The energy band gap of the barrier layer 136 may be controlled by the content (at%) of Al or In in the barrier layer 136.

The barrier layer 136 may include a semiconductor material having properties different from those of the channel layer 132. The barrier layer 136 may be different from the channel layer 132 in at least one of polarization characteristics, energy band gap, and lattice constant. For example, the barrier layer 136 may include a material having a different energy band gap from that of the channel layer 132. At this time, the barrier layer 136 may have a higher energy band gap than the channel layer 132 and may have a higher electric polarization rate than the channel layer 132. A two-dimensional electron gas 134 may be induced in the channel layer 132 with a relatively low electrical polarization rate by this barrier layer 136. In this respect, the barrier layer 136 may also be called a channel supply layer or a two-dimensional electron gas supply layer. A two-dimensional electron gas 134 may be formed within a portion of the channel layer 132 located below the interface between the channel layer 132 and the barrier layer 136. The two-dimensional electron gas 134 may have very high electron mobility.

The semiconductor device according to an implementation may include a plurality of barrier layers 136a, 136b, 136c stacked in a third direction D3. Referring to FIG. 1 to FIG. 3, a semiconductor device according to an implementation may include a first barrier layer 136a, a second barrier layer 136b positioned on the first barrier layer 136a, and a third barrier layer 136c positioned on the second barrier layer 136b.

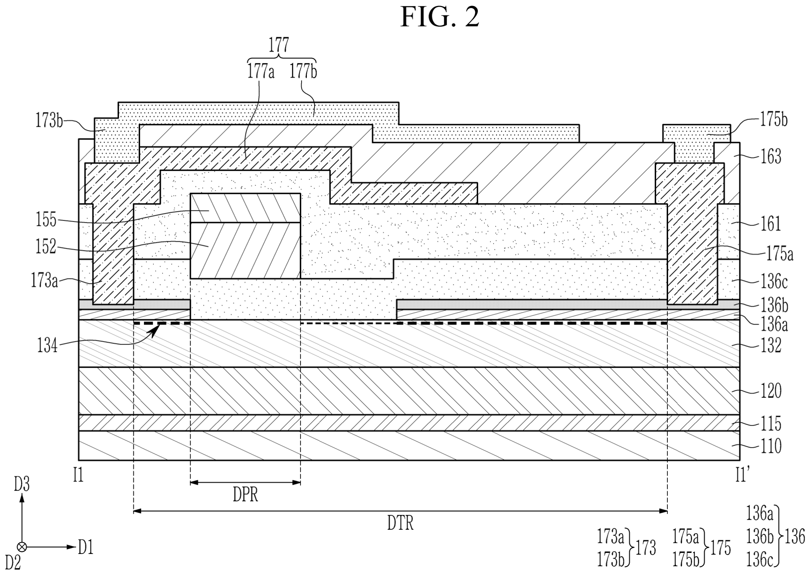

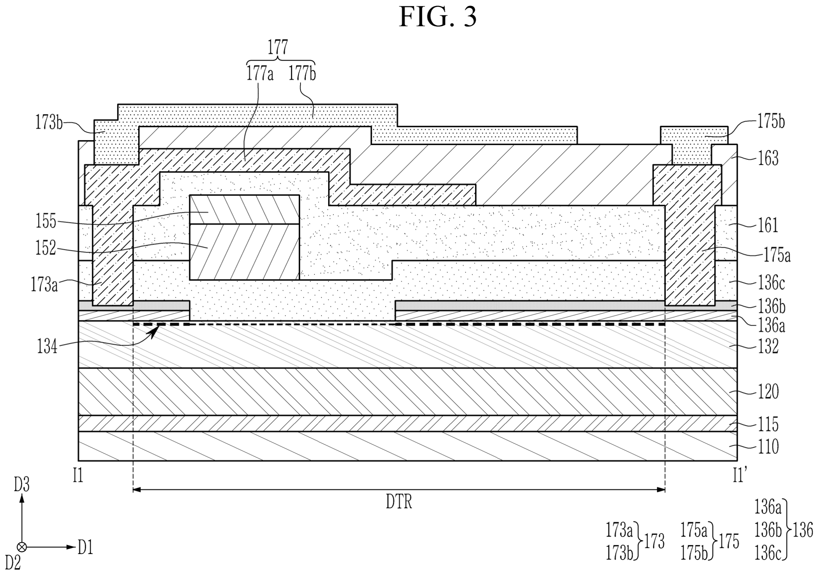

The first barrier layer 136a may be positioned directly on the channel layer 132. A portion of the first barrier layer 136a may be penetrated by the third barrier layer 136c. The first barrier layer 136a may be separated into two portions by the third barrier layer 136c. In FIG. 2 and FIG. 3, the first barrier layer 136a located on the left may include a portion overlapping with the source electrode 173 in the third direction D3, and the first barrier layer 136a located on the right may include a portion overlapping with the drain electrode 175 in the third direction D3. The first barrier layer 136a may not overlap with the gate electrode 155 and the gate semiconductor layer 152 in the third direction D3, which will be described later.

In an implementation, the first barrier layer 136a may have a thin thickness. The first barrier layer 136a may have a thinner thickness in the third direction D3 compared to the third barrier layer 136c. The first barrier layer 136a may have a thin thickness such that, during an ON operation of the semiconductor device according to the implementation, charges may flow from the source electrode 173 or the drain electrode 175 to the channel layer 132 across the first barrier layer 136a by tunneling. In an implementation, the thickness of the first barrier layer 136a along the third direction D3 may be greater than 0 and less than or equal to about 2 nm.

In an implementation, the first barrier layer 136a may be positioned directly on the channel layer 132. The lower surface of the first barrier layer 136a may be in contact with the upper surface of the channel layer 132. Depending on the properties of the first barrier layer 136a, the density of the two-dimensional electron gas 134 formed within the channel layer 132 may vary. For example, when the first barrier layer 136a includes AlGaN, the density of the two-dimensional electron gas 134 formed within the channel layer 132 may vary depending on the content (e.g., atomic percentage at%) of aluminum (Al) in the first barrier layer 136a. For example, as the content of aluminum (Al) in the first barrier layer 136a increases, the density of the two-dimensional electron gas 134 formed within the channel layer 132 may increase.

In a semiconductor device according to an implementation, the first barrier layer 136a may include aluminum (Al) having a relatively high content.. Accordingly, the channel layer 132 overlapping the first barrier layer 136a in the third direction D3 may have a high-density two-dimensional electron gas 134 positioned inside. In an implementation, the content of aluminum (Al) in the first barrier layer 136a may be greater than or equal to about 10 at% and less than or equal to about 30 at%. For example, the content of aluminum (Al) in the first barrier layer 136a may be about 30 at%. In an implementation, the content of aluminum (Al) in the first barrier layer 136a may be greater than or equal to the content of aluminum (Al) in the second barrier layer 136b. In an implementation, the content of aluminum (Al) in the first barrier layer 136a may be greater than the content of aluminum (Al) in the third barrier layer 136c.

The second barrier layer 136b may be positioned directly on the first barrier layer 136a. A portion of the second barrier layer 136b may be penetrated by the third barrier layer 136c. The second barrier layer 136b may be separated into two portions by the third barrier layer 136c. In FIG. 2 and FIG. 3, the second barrier layer 136b located on the left may include a portion overlapping with the source electrode 173 in the third direction D3, and the second barrier layer 136b located on the right may include a portion overlapping with the drain electrode 175 in the third direction D3. The second barrier layer 136b may not overlap the gate electrode 155 and the gate semiconductor layer 152 in the third direction D3, which will be described later. In an implementation, the second barrier layer 136b may have substantially the same width along the first direction D1 as the first barrier layer 136a. In an implementation, the content of aluminum (Al) may be the same throughout the entire area of the first barrier layer 136a. However, it is not limited thereto, and the content of aluminum (Al) may increase or decrease as it moves away from the upper surface of the channel layer 132.

Unlike what is shown in FIG. 2 and FIG. 3, another barrier layer may be interposed between the first barrier layer 136a and the second barrier layer 136b.

In an implementation, the second barrier layer 136b may have a thin thickness. For example, the second barrier layer 136b may have a thinner thickness in the third direction D3 compared to the third barrier layer 136c. The second barrier layer 136b may have a thin thickness such that, during an ON operation of the semiconductor device according to the implementation, charges may flow from the source electrode 173 or the drain electrode 175 to the channel layer 132 across the second barrier layer 136b by tunneling. In an implementation, the width of the second barrier layer 136b along the third direction D3 may be greater than 0 and less than or equal to about 2 nm. In an implementation, the second barrier layer 136b may have a thickness substantially equal to, but not limited to, the thickness of the first barrier layer 136a.

In an implementation, the second barrier layer 136b may be connected to the source electrode 173 or the drain electrode 175. Referring to FIG. 2 and FIG. 3, the second barrier layer 136b may be connected to one end of the source electrode 173 or one end of the drain electrode 175. The second barrier layer 136b may surround one side and a portion of the lower surface of the source electrode 173. The second barrier layer 136b may surround a portion of one side surface and a portion of the lower surface of the drain electrode 175. Unlike those shown in FIG. 2 and FIG. 3, the source electrode 173 or the drain electrode 175 may penetrate the second barrier layer 136b so that the lower surface of the source electrode 173 or the lower surface of the drain electrode 175 may be in contact with the upper surface of the first barrier layer 136a.

In an implementation, the second barrier layer 136b may include an n-type dopant material. For example, when the second barrier layer 136b includes AlGaN, the second barrier layer 136b may be doped with silicon (Si). For example, the doping concentration of silicon (Si) included in the second barrier layer 136b may be greater than or equal to about 1.0×10¹⁷ cm⁻³ and less than or equal to about 1.0×10²⁰ cm⁻³, but is not limited thereto. In the semiconductor device according to the implementation, the second barrier layer 136b may include an n-type dopant material other than silicon (Si).

In a semiconductor device according to an implementation, the source electrode 173 and the drain electrode 175 may not be directly connected to the channel layer 132, but may be connected to a second barrier layer 136b doped with silicon (Si). In an implementation, as the second barrier layer 136b is doped with silicon (Si), the contact resistance at the interface between the source electrode 173 and the second barrier layer 136b, or the drain electrode 175 and the second barrier layer 136b may be reduced, and thus the electrical characteristics of the semiconductor device according to the implementation may be improved.

In an implementation, the content of aluminum (Al) in the second barrier layer 136b may be less than or equal to the content of aluminum (Al) in the first barrier layer 136a. In an implementation, the content of aluminum (Al) in the second barrier layer 136b may be greater than or equal to the content of aluminum (Al) in the third barrier layer 136c.

The third barrier layer 136c may be positioned directly on the second barrier layer 136b. The third barrier layer 136c may include an area in contact with the upper surface of the second barrier layer 136b. The third barrier layer 136c may include a portion (e.g., a second portion) penetrating the first barrier layer 136a and the second barrier layer 136b in the third direction D3. Among the entire area of the third barrier layer 136c, the portion penetrating the first barrier layer 136a and the second barrier layer 136b may include an portion overlapping the gate semiconductor layer 152 and the gate electrode 155 in the third direction D3. The third barrier layer 136c may cover the upper surface and side surface of the second barrier layer 136b. The third barrier layer 136c may cover the side surface of the first barrier layer 136a. A portion of the third barrier layer 136c (e.g., a first portion) may be penetrated by the source electrode 173 and the drain electrode 175.

The third barrier layer 136c may be thicker than the first barrier layer 136a or the second barrier layer 136b. For example, the thickness of the third barrier layer 136c along the third direction D3 may be about 20 nm, but is not limited thereto.

In a semiconductor device according to an implementation, AlGaN included in the third barrier layer 136c may include aluminum (Al) having a relatively low content. In an implementation, the content of aluminum (Al) in the third barrier layer 136c may be lower than the content of aluminum (Al) in the first barrier layer 136a. For example, the content of aluminum (Al) in the third barrier layer 136c may be greater than 0 and less than or equal to about 10 at%. Accordingly, within a portion of the channel layer 132 in contact with the third barrier layer 136c in the third direction D3, a two-dimensional electron gas 134 having a lower density may be present, compared to a portion of the channel layer 132 in contact with the first barrier layer 136a in the third direction D3.

In the channel layer 132 of the semiconductor device according to the implementation, the density of the two-dimensional electron gas 134 positioned in the portion where the upper surface contacts the first barrier layer 136a may be higher than the density of the two-dimensional electron gas 134 positioned in the portion where the upper surface contacts the third barrier layer 136c. This may be due to the characteristic that the first barrier layer 136a includes AlGaN having a higher content of aluminum (Al) compared to the third barrier layer 136c.

In a semiconductor device such as those illustrated in FIG. 1 to FIG. 3, the threshold voltage may vary depending on the density of a two-dimensional electron gas 134 located within a channel layer 132 adjacent to the gate electrode 155. For example, when the density of the two-dimensional electron gas 134 located within the channel layer 132 adjacent to the gate electrode 155 increases, the threshold voltage of the semiconductor device according to the implementation may be lowered. If the threshold voltage is excessively lowered, the ON/OFF characteristics of the semiconductor device according to the implementation may deteriorate.

In the semiconductor device according to the implementation, the third barrier layer 136c may be located under the gate electrode 155, while the first barrier layer 136a and the second barrier layer 136b may not be present under the gate electrode 155. In an implementation, the two-dimensional electron gas 134 may have a low density in a portion of the channel layer 132 where the upper surface is in contact with the third barrier layer 136c. In an implementation, a first barrier layer 136a may be positioned relatively far from the gate electrode 155 (for example, below the source electrode 173 or the drain electrode 175), and the two-dimensional electron gas 134 may have a high density in a portion of the channel layer 132 where the upper surface is in contact with the first barrier layer 136a.

In the implementation, the channel layer 132 may have a generally high density of the two-dimensional electron gas 134, while the portion adjacent to the gate electrode 155 may have a locally low density of the two-dimensional electron gas 134. According to the implementation, the density of the two-dimensional electron gas 134 in the channel layer 132 may be increased without a change in threshold voltage, and accordingly, the electrical characteristics of the semiconductor device may be improved.

The semiconductor device according to the implementation may further include a gate semiconductor layer 152 positioned over the barrier layer 136. The gate semiconductor layer 152 may be located between the barrier layer 136 and the gate electrode 155. In an implementation, the gate semiconductor layer 152 may form a Schottky contact with the gate electrode 155 to be described later, but it is not limited thereto. The gate semiconductor layer 152 may overlap the gate electrode 155 in the third direction D3. The upper surface of the gate semiconductor layer 152 may be entirely covered by a gate electrode 155.

The gate semiconductor layer 152 may be positioned between the source electrode 173 and the drain electrode 175 in the first direction D1. The gate semiconductor layer 152 may be spaced apart from the source electrode 173 and the drain electrode 175 in the first direction D1. The gate semiconductor layer 152 may be positioned closer to the source electrode 173 than to the drain electrode 175. That is, the distance between the gate semiconductor layer 152 and the source electrode 173 may be smaller than the distance between the gate semiconductor layer 152 and the drain electrode 175.

The gate semiconductor layer 152 may include a nitride including group III-V materials, for example, Al, Ga, In, B, or a combination thereof. The gate semiconductor layer 152 may include AlₓIn_{y}Ga_{1-x-y}N (0 ≤ x ≤ 1, 0≤y≤1, x y ≤ 1). For example, the gate semiconductor layer 152 may include AIN, GaN, InN, InGaN, AlGaN, AlInN, AlInGaN, or a combination thereof. The gate semiconductor layer 152 may include a material having a different energy band gap from the barrier layer 136. For example, the gate semiconductor layer 152 may include GaN, and the barrier layer 136 may include AlGaN. The gate semiconductor layer 152 may be doped with a predetermined impurity. At this time, the impurity doped into the gate semiconductor layer 152 may be a p-type dopant capable of providing holes. For example, the gate semiconductor layer 152 may include GaN doped with p-type impurities. That is, the gate semiconductor layer 152 may be made of a p-GaN layer. However, it is not limited to, and the gate semiconductor layer 152 may be a p-AlGaN layer. The impurity doped into the gate semiconductor layer 152 may be magnesium (Mg). The gate semiconductor layer 152 may be formed of a single layer or multiple layers.

A depletion region DPR may be formed within the channel layer 132 by the gate semiconductor layer 152. The depletion region DPR may be located within the drift region DTR and may have a narrower width than the drift region DTR. As the gate semiconductor layer 152 having a different energy band gap from the barrier layer 136 is positioned on the barrier layer 136, the energy band level of a portion of the barrier layer 136 overlapping the gate semiconductor layer 152 may be increased. Accordingly, a depletion region DPR may be formed in the portion of the channel layer 132 overlapping the gate semiconductor layer 152. The depletion region DPR may be a portion in the channel path of the channel layer 132 where a two-dimensional electron gas 134 is not formed or has a lower electron concentration than the remaining portion. That is, the depletion region DPR may mean a portion where the flow of two-dimensional electron gas 134 is cut off within the drift region DTR. As a depletion region DPR is generated, current may not flow between the source electrode 173 and the drain electrode 175, and the channel path may be blocked. Accordingly, the semiconductor device may have normally off characteristics.

The gate electrode 155 may be located on the barrier layer 136. The gate electrode 155 may overlap a portion of the barrier layer 136 in the third direction D3. The gate electrode 155 may overlap a part of the drift region DTR of the channel layer 132 in the third direction D3. The gate electrode 155 may be positioned between the source electrode 173 and the drain electrode 175 in the first direction D1. The gate electrode 155 may be spaced apart from the source electrode 173 and the drain electrode 175 in the first direction D1. The gate electrode 155 may be positioned closer to the source electrode 173 than to the drain electrode 175. That is, the distance between the gate electrode 155 and the source electrode 173 may be shorter than the distance between the gate electrode 155 and the drain electrode 175. A low voltage or a ground voltage may be applied to the source electrode 173, whereas a very high voltage level may be applied to the drain electrode 175. In the semiconductor device illustrated in FIG. 1 to FIG. 3, by spacing apart the gate electrode 155 and the drain electrode 175, the influence of the high electric field that may occur between the gate electrode 155 and the drain electrode 175 may be minimized. In an implementation, it is controlled such that a two-dimensional electron gas 134 having a low density is present in a portion of the channel layer 132 adjacent to one side of the gate electrode 155 facing the drain electrode 175. Accordingly, the influence of a high electric field that may occur between the gate electrode 155 and the drain electrode 175 can be reduced.

The gate electrode 155 may extend along the second direction D2 on a plane. That is, the gate electrode 155 may have a bar shape that extends long along the second direction D2 on a plane.

The gate electrode 155 may include a conductive metal nitride. For example, the metal of the metal nitride may include tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), ruthenium (Ru), iridium (Ir), osmium (Os), silver (Ag), gold (Au), zinc (Zn), vanadium (V), or combinations thereof. Additionally, the gate electrode 155 may include a metal nitride including titanium nitride (TiN), titanium silicon nitride (TiSiN), tantalum nitride (TaN), tantalum silicon nitride (TaSiN), tantalum titanium nitride (TaTiN), titanium aluminum nitride (TiAIN), tantalum aluminum nitride (TaAlN), tungsten nitride (WN), titanium aluminum carbon nitride (TiAIC-N), or a combination thereof.

In an implementation, the semiconductor device may be a normally-off semiconductor device (HEMT, High Electron Mobility Transistor). In a normal state where no voltage is applied to the gate electrode 155, a depletion region DPR exists and the semiconductor device may be in an off state. When a voltage higher than the threshold voltage is applied to the gate electrode 155, the depletion region DPR disappears, and the two-dimensional electron gas 134 within the drift region DTR may be connected without being disconnected. That is, a two-dimensional electron gas 134 may be formed throughout the channel path between the source electrode 173 and the drain electrode 175, and the semiconductor device may be turned on. In summary, a semiconductor device may include semiconductor layers having different electrical polarization characteristics, and a semiconductor layer having a relatively large polarization rate may induce a two-dimensional electron gas 134 in another semiconductor layer heterojunction therewith. This two-dimensional electron gas 134 may be used as a channel between the source electrode 173 and the drain electrode 175, and the flow of this two-dimensional electron gas 134 may be continued or interrupted by the bias voltage applied to the gate electrode 155. In the gate-off state, the flow of two-dimensional electron gas 134 is blocked, so that no current may flow between the source electrode 173 and the drain electrode 175. As the flow of two-dimensional electron gas 134 continues in the gate-on state, current may flow between the source electrode 173 and the drain electrode 175.

The above description is made with respect to the case where the semiconductor device is a normally-off high electron mobility transistor, but is not limited thereto. For example, the semiconductor device may be a normally-on high electron mobility transistor. In the case of a normally-on high electron mobility transistor, the gate semiconductor layer 152 may be omitted, and thus the gate electrode 155 may be positioned directly on the barrier layer 136. That is, the gate electrode 155 may be in contact with the barrier layer 136. However, it is not limited thereto, and a gate dielectric layer may be interposed between the gate electrode 155 and the barrier layer 136. In this structure, a two-dimensional electron gas 134 may be used as a channel when no voltage is applied to the gate electrode 155, and a current flow may occur between the source electrode 173 and the drain electrode 175. When a negative voltage is applied to the gate electrode 155, a depletion region DPR may be generated under the gate electrode 155, thereby interrupting the flow of the two-dimensional electron gas 134.

The semiconductor device according to the implementation may further include protective layers 161, 163 positioned over the barrier layer 136 and the gate electrode 155. For example, a semiconductor device according to an implementation may further include a first protective layer 161 and a second protective layer 163 positioned on the first protective layer 161.

The first protective layer 161 may cover the upper surface of the barrier layer 136 and the gate electrode 155, and may cover the side surface of the gate electrode 155 and the side surface of the gate semiconductor layer 152. The lower surface of the first protective layer 161 may be in contact with the barrier layer 136, the gate electrode 155, and the gate semiconductor layer 152. The upper surface of the first protective layer 161 may be in contact with the second protective layer 163.

The barrier layer 136, the gate electrode 155, or the like may be protected by protective layers 161, 163, and may be isolated from other components. The protective layers 161, 163 may include an insulating material. For example, the protective layers 161, 163 may include oxides such as silicon oxide (SiO₂) or aluminum oxide (Al₂O₃). As another example, the protective layers 161, 163 may include a nitride such as silicon nitride (SiN_{X}) or an oxynitride such as silicon oxynitride (SiON). The protective layer 161, 163 may include the same material, or may include different materials from each other. When the protective layers 161, 163 are made of the same material, the boundary between the protective layers 161, 163 may not be visually distinguishable. The protective layers 161, 163 may each be composed of a single layer or multiple layers.

The source electrode 173 and the drain electrode 175 may be positioned on the channel layer 132. The source electrode 173 and the drain electrode 175 may be spaced apart from each other in the first direction D1, and a gate electrode 155 and a gate semiconductor layer 152 may be positioned between the source electrode 173 and the drain electrode 175. The gate electrode 155 and the gate semiconductor layer 152 are spaced apart from the source electrode 173 and the drain electrode 175 in the first direction D1. The source electrode 173 may be electrically connected to the second barrier layer 136b on one side of the gate electrode 155. The drain electrode 175 may be electrically connected to the second barrier layer 136b on the other side of the gate electrode 155. The source electrode 173 and the drain electrode 175 may be located outside the drift region DTR of the channel layer 132. In an implementation, the interface between the source electrode 173 and the second barrier layer 136b may be one edge of the drift region DTR. Similarly, the interface between the drain electrode 175 and the second barrier layer 136b may be the other edge of the drift region DTR.

Unlike those illustrated in FIG. 2 and FIG. 3, the second barrier layer 136b may not include a recess in the area connected to the source electrode 173 or the drain electrode 175. In this case, the source electrode 173 and the drain electrode 175 may be positioned on the upper surface of the second barrier layer 136b. The lower surfaces of the source electrode 173 and the lower surfaces of the drain electrode 175 may be in contact with the upper surface of the second barrier layer 136b. The portion of the second barrier layer 136b in contact with the source electrode 173 and the drain electrode 175 may be highly doped. In this case, carriers having passed through the two-dimensional electron gas 134 may be delivered to the source electrode 173 and the drain electrode 175 via the first barrier layer 136a and heavily doped portion of the second barrier layer 136b. The source electrode 173 and the drain electrode 175 may not be in direct horizontal contact with the two-dimensional electron gas 134. The horizontal direction may mean a direction parallel to the upper surface of the channel layer 132 or the barrier layer 136.

The source electrode 173 and the drain electrode 175 may extend along the second direction D2 on a plane. That is, the source electrode 173 and the drain electrode 175 may have a rod shape that extends long along the second direction D2 on a plane. The source electrode 173 and the drain electrode 175 may extend in a direction parallel to each other. The source electrode 173 and the drain electrode 175 may extend in a direction parallel to the gate electrode 155.

The source electrode 173 and the drain electrode 175 may include a conductive material. For example, the source electrode 173 and the drain electrode 175 may include a metal, a metal alloy, a conductive metal nitride, a metal silicide, a doped semiconductor material, a conductive metal oxide, or a conductive metal nitride. For example, the source electrode 173 and the drain electrode 175 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAlN), tungsten nitride (WN), ruthenium (Ru), titanium aluminum (TiAl), titanium aluminum carbide nitride (TiAIC-N), titanium aluminum carbide (TiAIC), titanium carbide (TiC), tantalum carbide nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or combinations thereof but they are not limited thereto. The source electrode 173 and the drain electrode 175 may be formed of a single layer or multiple layers. In an implementation, the source electrode 173 and the drain electrode 175 may be in ohmic contact with the second barrier layer 136b.

The source electrode 173 may include a lower source electrode 173a and an upper source electrode 173b. The upper source electrode 173b may be positioned on the lower source electrode 173a. In an implementation, the lower source electrode 173a may be in direct contact with the second barrier layer 136b and may be electrically connected to the second barrier layer 136b. The upper source electrode 173b may not be in direct contact with the second barrier layer 136b and may be electrically connected to the second barrier layer 136b through the lower source electrode 173a.

The drain electrode 175 may include a lower drain electrode 175a and an upper drain electrode 175b. The upper drain electrode 175b may be positioned on the lower drain electrode 175a. The lower drain electrode 175a may be in direct contact with the second barrier layer 136b and may be electrically connected to the second barrier layer 136b. The upper drain electrode 175b may not be in direct contact with the second barrier layer 136b and may be electrically connected to the second barrier layer 136b through the lower drain electrode 175a.

The lower source electrode 173a and the lower drain electrode 175a may also be positioned on the first protective layer 161. The lower source electrode 173a and the lower drain electrode 175a may be positioned between the first protective layer 161 and the second protective layer 163. Trenches penetrating the first protective layer 161 and the barrier layer 136, and recessing an upper surface of the second barrier layer 136b, may be positioned on opposite sides of the gate electrode 155, spaced apart from each other. The lower source electrode 173a and the lower drain electrode 175a may be positioned in trenches located on both sides of the gate electrode 155, respectively. The lower source electrode 173a and the lower drain electrode 175a may be formed to fill the inside of the trench. Within the trench, the lower source electrode 173a and the lower drain electrode 175a may be in contact with the second barrier layer 136b and the third barrier layer 136c. The second barrier layer 136b may form the bottom surface and side walls of the trench, and the third barrier layer 136c may form the side walls of the trench. Accordingly, the lower source electrode 173a and the lower drain electrode 175a may be in contact with the upper surface and side surface of the second barrier layer 136b. Additionally, the lower source electrode 173a and the lower drain electrode 175a may be in contact with the side surface of the third barrier layer 136c. That is, the lower source electrode 173a and the lower drain electrode 175a may cover the side surfaces of the second barrier layer 136b and the barrier layer 136. The upper surfaces of the lower source electrode 173a and the lower drain electrode 175a may protrude above an upper surface of the first protective layer 161. Additionally, at least one of the lower source electrode 173a and the lower drain electrode 175a may cover at least a portion of the upper surface of the first protective layer 161. The second protective layer 163 may be positioned over the lower source electrode 173a and the lower drain electrode 175a. At least a portion of the lower source electrode 173a and the lower drain electrode 175a may be covered by a second protective layer 163.

The semiconductor device may further include a first field dispersion layer 177a positioned over the first protective layer 161. The first field dispersion layer 177a may be located between the lower source electrode 173a and the drain electrode 175. The gate electrode 155 may be covered by a first field dispersion layer 177a. The first field dispersion layer 177a may be electrically connected to the source electrode 173. For example, the first field dispersion layer 177a may be connected to the lower source electrode 173a. The first field dispersion layer 177a may include the same material as the lower source electrode 173a and may be located in the same layer as the lower source electrode 173a. The first field dispersion layer 177a may be formed simultaneously with the lower source electrode 173a in the same process. The boundary between the first field dispersion layer 177a and the lower source electrode 173a is not clear, and the first field dispersion layer 177a may be formed integrally with the lower source electrode 173a. However, it is not limited thereto, and the first field dispersion layer 177a may be a separate component separated from the lower source electrode 173a. Additionally, the first field dispersion layer 177a may be located in a different layer from the lower source electrode 173a and may be formed in a different process. In some cases, the first field dispersion layer 177a may be electrically connected to the gate electrode 155. For example, an opening overlapping the gate electrode 155 may be formed in the first protective layer 161, and the first field dispersion layer 177a may be connected to the gate electrode 155 through the opening. At this time, the first field dispersion layer 177a may not be connected to the source electrode 173.

The semiconductor device may include a second field dispersion layer 177b positioned over a second protective layer 163. The second field dispersion layer 177b may form a field dispersion layer together with the first field dispersion layer 177a. The second field dispersion layer 177b may be located between the source electrode 173 and the drain electrode 175. The second field dispersion layer 177b may overlap the gate electrode 155 in the third direction D3. The second field dispersion layer 177b may overlap the first field dispersion layer 177a in the third direction D3. The gate electrode 155 and the first field dispersion layer 177a may be covered by a second field dispersion layer 177b. The second field dispersion layer 177b may be wider than the width of the first field dispersion layer 177a. The second field dispersion layer 177b may entirely cover the first field dispersion layer 177a. However, it is not limited thereto, and the width, positional relationship, etc. of the first field dispersion layer 177a and the second field dispersion layer 177b may be changed in various ways. The second field dispersion layer 177b may be electrically connected to the source electrode 173. For example, the second field dispersion layer 177b may be connected to the upper source electrode 173b. The second field dispersion layer 177b may include the same material as the upper source electrode 173b and may be located in the same layer as the upper source electrode 173b. The second field dispersion layer 177b may be formed simultaneously with the upper source electrode 173b in the same process. The boundary between the second field dispersion layer 177b and the upper source electrode 173b is not clear, and the second field dispersion layer 177b may be formed integrally with the the upper source electrode 173b. However, it is not limited thereto, and the second field dispersion layer 177b may be a separate component separated from the upper source electrode 173b. Additionally, the second field dispersion layer 177b may be located in a different layer from the upper source electrode 173b and may be formed in a different process.

In some implementations, at least one of the first field dispersion layer 177a and the second field dispersion layer 177b may be omitted. For example, the semiconductor device may include a first field dispersion layer 177a and may not include a second field dispersion layer 177b. Alternatively, the semiconductor device may include a second field dispersion layer 177b and may not include a first field dispersion layer 177a.

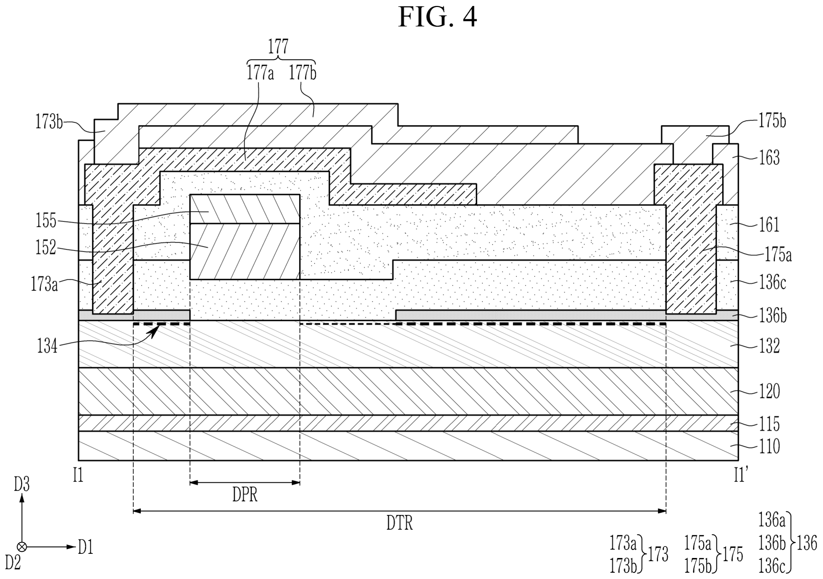

FIG. 4 is a cross-sectional view showing a semiconductor device according to an implementation. The semiconductor device illustrated in FIG. 4 has many similarities to the previous implementations, so the following description focuses mainly on the differences from the previous implementations.

Referring to FIG. 4, the semiconductor device according to the implementation may not include the first barrier layer 136a described with reference to FIG. 1 to FIG. 3. In an implementation, a second barrier layer 136b may be positioned directly on the channel layer 132. Among the entire upper surface of the channel layer 132, a portion that is not in contact with the third barrier layer 136c may be in contact with the second barrier layer 136b.

In an implementation, the second barrier layer 136b may include AlGaN having a higher content of aluminum (Al) than the third barrier layer 136c. For example, the content of aluminum (Al) in the second barrier layer 136b may be greater than or equal to about 10 at% and less than or equal to about 30 at%.

In an implementation, the second barrier layer 136b may be doped with silicon (Si). For example, the doping concentration of silicon (Si) included in the second barrier layer 136b may be greater than or equal to 1.0×10¹⁷ cm⁻³ and less than or equal to 1.0×10²⁰ cm⁻³, but is not limited thereto. In the semiconductor device according to the implementation, the second barrier layer 136b may include an n-type dopant material other than silicon (Si).

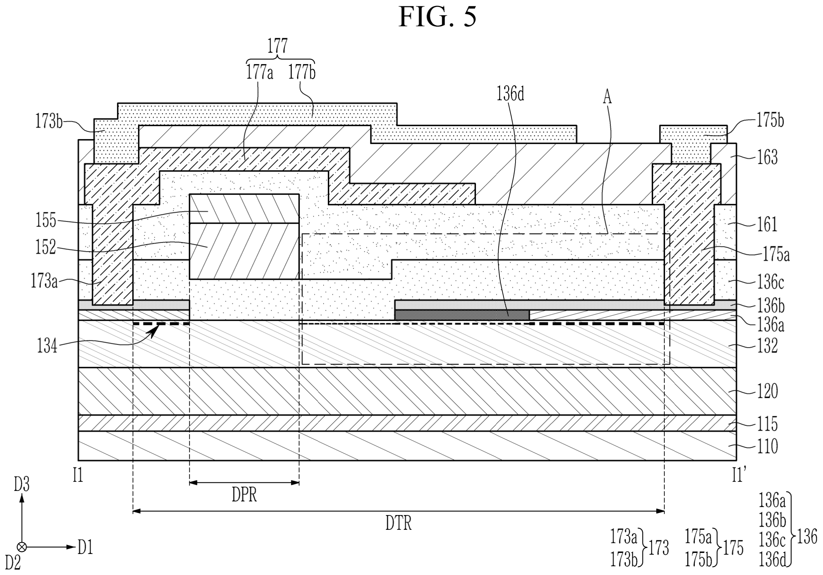

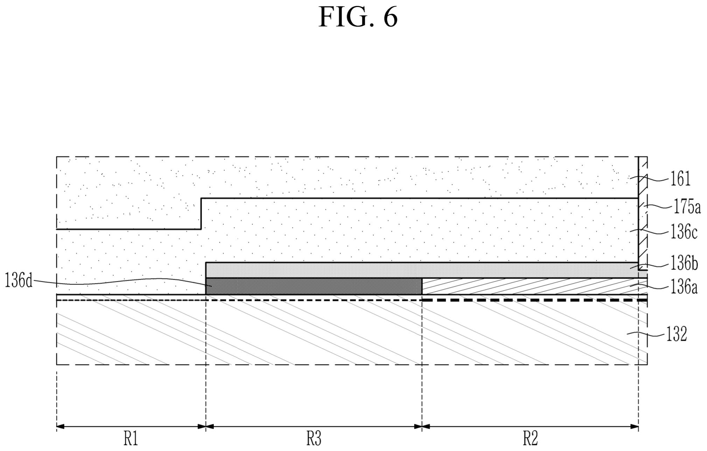

FIG. 5 and FIG. 6 are drawings for explaining a semiconductor device according to an implementation. The semiconductor devices illustrated in FIG. 5 and FIG. 6 have many similarities to the previous implementations, so the following description focuses mainly on the differences from the previous implementations. FIG. 5 is a cross-sectional view showing a semiconductor device according to an implementation, and FIG. 6 is an enlarged cross-sectional view of area A of FIG. 5.

Referring to FIG. 5 and FIG. 6, the semiconductor device according to the implementation may further include a fourth barrier layer 136d.

In an implementation, the fourth barrier layer 136d may be positioned between the gate electrode 155 and the drain electrode 175. The fourth barrier layer 136d may be positioned on the upper surface of the channel layer 132. The fourth barrier layer 136d may be in contact with a portion of the upper surface and the lower surface of the channel layer 132. The fourth barrier layer 136d may be positioned at substantially the same level as the first barrier layer 136a. The fourth barrier layer 136d may be located on one side of the first barrier layer 136a. The fourth barrier layer 136d may have one side surface in contact with the first barrier layer 136a. The fourth barrier layer 136d may have its upper surface covered by the second barrier layer 136b.

In an implementation, the fourth barrier layer 136d may include AlGaN. In an implementation, the content of aluminum (Al) in the fourth barrier layer 136d may be different from the content of aluminum (Al) in the first barrier layer 136a and the third barrier layer 136c. For example, the content of aluminum (Al) in the fourth barrier layer 136d may be smaller than the content of aluminum (Al) in the first barrier layer 136a. For example, the content of aluminum (Al) in the fourth barrier layer 136d may be greater than the content of aluminum (Al) in the third barrier layer 136c.

Referring to FIG. 6, in the implementation, the channel layer 132 may include a first region R1 having an upper surface in contact with the third barrier layer 136c, a second region R2 having an upper surface in contact with the first barrier layer 136a, and a third region R3 having an upper surface in contact with the fourth barrier layer 136d. In an implementation, the density of the two-dimensional electron gas 134 located in the second region R2 may be higher than the density of the two-dimensional electron gas 134 located in the first region R1. In an implementation, the density of the two-dimensional electron gas 134 located in the third region R3 may be higher than the density of the two-dimensional electron gas 134 located in the first region R1 and lower than the density of the two-dimensional electron gas 134 located in the second region R2.

As illustrated in FIG. 5 and FIG. 6, in an implementation, the density of the two-dimensional electron gas 134 positioned within the channel layer 132 may become lower as it approaches the edge of the gate electrode 155. According to the implementation, electric field concentration near the edge of the gate electrode 155 may be prevented, thereby preventing breakdown of the semiconductor device.

As illustrated in FIG. 5 and FIG. 6, in the implementation, the density of the two-dimensional electron gas 134 in the channel layer 132 may be higher in regions closer to the drain electrode 175. According to an implementation, when the semiconductor device is turned on, the current flowing from the drain electrode 175 may be dispersed, and thus, hot carrier injection (HCI) at the drain electrode 175 may be alleviated, thereby improving the reliability of the semiconductor device according to the implementation.

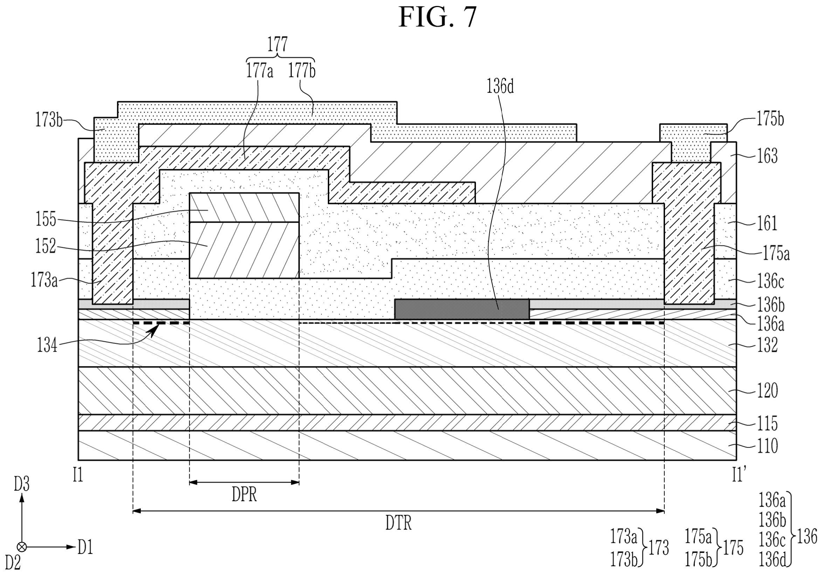

FIG. 7 is a cross-sectional view showing a semiconductor device according to an implementation. The semiconductor device illustrated in FIG. 7 has many similarities to the previous implementations, so the following description focuses mainly on the differences from the previous implementations.

In the semiconductor device according to the implementation, the thickness of the fourth barrier layer 136d may be different from that described with reference to FIG. 5 and FIG. 6. Referring to FIG. 7, the fourth barrier layer 136d may be positioned at substantially the same level as the first barrier layer 136a. In an implementation, the fourth barrier layer 136d may have a thickness thicker than the first barrier layer 136a. The fourth barrier layer 136d may be located on one side of the first barrier layer 136a and the second barrier layer 136b. The fourth barrier layer 136d may have one side surface in contact with the first barrier layer 136a and the second barrier layer 136b.

In FIG. 7, the upper surface of the fourth barrier layer 136d is depicted as being located at the same level as the upper surface of the second barrier layer 136b, but is not limited thereto. For example, the upper surface of the fourth barrier layer 136d may be located at a lower or higher level than the upper surface of the second barrier layer 136b.

Referring to FIG. 7, the upper surface of the fourth barrier layer 136d may be covered by the third barrier layer 136c. Unlike that shown in FIG. 7, the upper surface of the fourth barrier layer 136d may not be covered by the third barrier layer 136c. In this case, the upper surface of the fourth barrier layer 136d may be covered by the first protective layer 161.

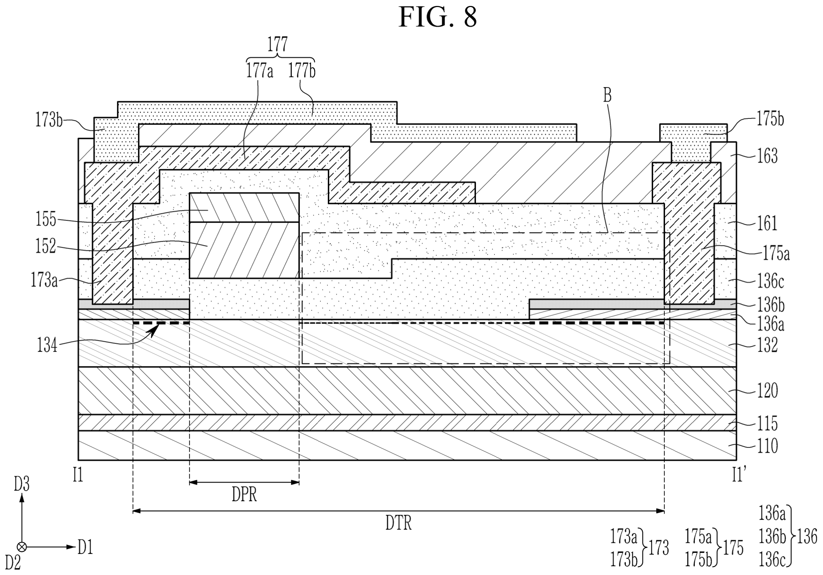

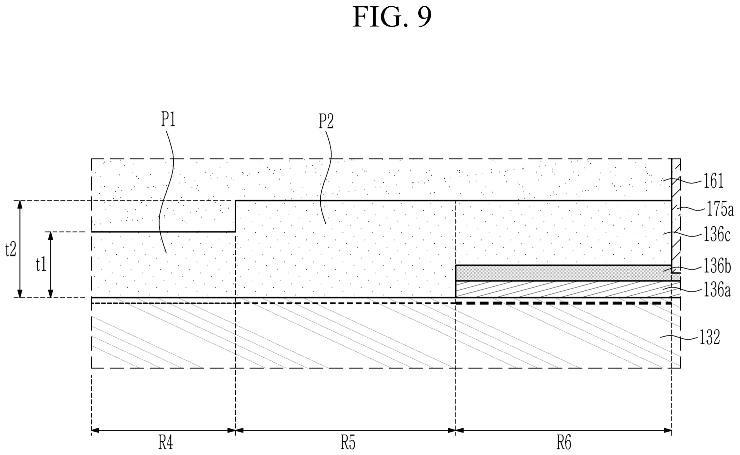

FIG. 8 and FIG. 9 are drawings for explaining a semiconductor device according to an implementation. The semiconductor devices illustrated in FIG. 8 and FIG. 9 have many similarities to the previous implementations, so the following description focuses mainly on the differences from the previous implementations. FIG. 8 is a cross-sectional view showing a semiconductor device according to an implementation, and FIG. 9 is an enlarged cross-sectional view of area B of FIG. 8. In a semiconductor device according to an implementation, the third barrier layer 136c may include portions having different thicknesses.

In a portion where the channel layer 132 is in contact with the third barrier layer 136c, the third barrier layer 136c may include a first part P1 having a first thickness t1 and a second part P2 having a second thickness t2. The second thickness t2 may be thicker than the first thickness t1. Referring to FIG. 8 and FIG. 9, the first part P1 may be adjacent to the gate electrode 155. The second part P2 may be located at one side of the first part P1. The second part P2 may be located between the first part P1 and the first barrier layer 136a, or between the first part P1 and the second barrier layer 136b.

Referring to FIG. 9, the channel layer 132 may include a fourth region R4 having an upper surface in contact with a first part P1 of the third barrier layer 136c, a fifth region R5 having an upper surface in contact with a second part P2 of the third barrier layer 136c, and a sixth region R6 having an upper surface in contact with the first barrier layer 136a. In an implementation, the density of the two-dimensional electron gas 134 included in the fifth region R5 may be higher than the density of the two-dimensional electron gas 134 located in the fourth region R4. In an implementation, the density of the two-dimensional electron gas 134 located in the fifth region R5 may be lower than the density of the two-dimensional electron gas 134 located in the sixth region R6.

In a semiconductor device such as that described with reference to FIG. 1 to FIG. 9, when the content of aluminum (Al) in the barrier layer 136 is the same, the density of the two-dimensional electron gas 134 formed in the channel layer 132 may increase as the thickness of the barrier layer 136 increases. Referring to FIG. 8 and FIG. 9, the second part P2 of the third barrier layer 136c may have a thicker thickness compared to the first part P1, and accordingly, the two-dimensional electron gas 134 located in the fifth region R5 in contact with the second part P2 may have a higher density than the two-dimensional electron gas 134 located in the fourth region R4 in contact with the first part P1.

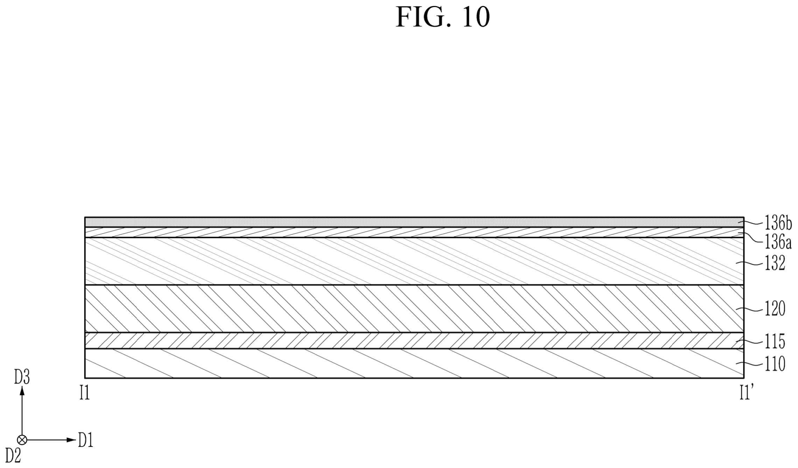

Next, a method for manufacturing a semiconductor device according to one implementation will be described with reference to FIG. 10 to FIG. 18. In addition, reference may be made to FIG.s 1 to 3 described above.

FIG.s 10 to 18 are cross-sectional views showing a manufacturing process of a semiconductor device according to an implementation in the order of the process.

As illustrated in FIG. 10, a seed layer 115, a buffer layer 120, a channel layer 132, a first barrier layer 136a, and a second barrier layer 136b may be sequentially formed on a substrate 110.

For example, the seed layer 115, buffer layer 120, channel layer 132, first barrier layer 136a, and second barrier layer 136b may be formed sequentially, using an epitaxial growth method. The seed layer 115 may be first formed on a substrate 110, and the buffer layer 120 may be formed on the seed layer 115. The buffer layer 120 may include a superlattice layer and a high-resistance layer. The channel layer 132 may be formed on the buffer layer 120, the first barrier layer 136a may be formed on the channel layer 132, and the second barrier layer 136b may be formed on the first barrier layer 136a. In the implementation, the first barrier layer 136a and the second barrier layer 136b may have a thinner thickness compared to the other layers. For example, the thickness of the first barrier layer 136a and the second barrier layer 136b may be greater than 0 nm and less than about 2 nm, respectively, but is not limited thereto.

For example, equipment for growing the seed layer 115, buffer layer 120, channel layer 132, barrier layer 136a, 136b, and gate semiconductor material layer 152L to be described later may use metal organic chemical vapor deposition (MOCVD), hydride vapor phase epitaxy (HVPE), or molecular beam epitaxy (MBE).

The seed layer 115, the buffer layer 120, the channel layer 132, the barrier layer 136a, 136b, and a gate semiconductor material layer 152L to be described later may be formed of the same base semiconductor material. However, the content of materials included in each layer may be different depending on the role of each layer and the performance required for the semiconductor device.

For example, the substrate 110 may include Si, the seed layer 115 may include AIN, and the superlattice layer of the buffer layer 120 may have a structure in which layers made of AlGaN and layers made of GaN are repeatedly laminated. The high-resistance layer of the buffer layer 120 may include GaN, the channel layer 132 may include GaN, and the barrier layer 136a, 136b may include AlGaN. In an implementation, the first barrier layer 136a and the second barrier layer 136b may include AlGaN having different content of aluminum (Al). For example, the first barrier layer 136a may have a higher content of aluminum (Al) than a content of aluminum in the second barrier layer 136b. However, it is not limited thereto, and the first barrier layer 136a and the second barrier layer 136b may have substantially the same content of aluminum (Al).

The channel layer 132 and the barrier layers 136a, 136b may be doped with impurities or may not be doped. In an implementation, the second barrier layer 136b may be doped with an n-type impurity, for example, silicon (Si).

Since the lattice structure of Si and the lattice structure of GaN are different, it may not be easy to grow a channel layer 132 made of GaN directly on a substrate 110 made of Si. Therefore, by first forming a seed layer 115 or a buffer layer 120 on the substrate 110 and then forming the channel layer 132, the lattice structure of the channel layer 132 may be stably formed.

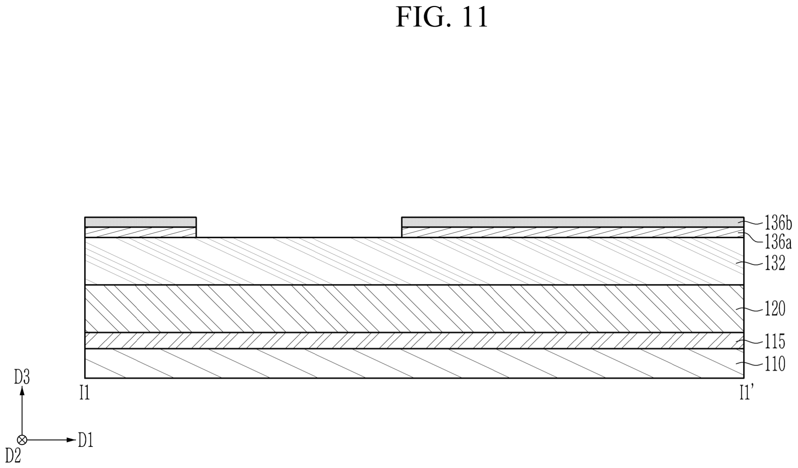

As illustrated in FIG. 11, a portion of the first barrier layer 136a and a portion of the second barrier layer 136b may be removed. The process of removing the first barrier layer 136a and the second barrier layer 136b may be performed by a dry etching process or a wet etching process. In an implementation, the first barrier layer 136a and the second barrier layer 136b may be etched simultaneously in the same process. In the process of etching the first barrier layer 136a and the second barrier layer 136b, an etchant having a higher etching selectivity for the first barrier layer 136a and the second barrier layer 136b compared to the material included in the channel layer 132 may be used.

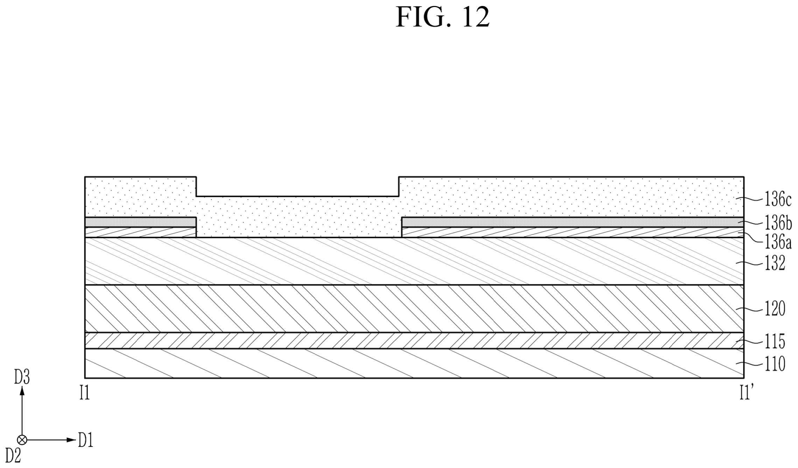

Next, as illustrated in FIG. 12, a third barrier layer 136c may be formed on the channel layer 132 and the second barrier layer 136b. The third barrier layer 136c may be deposited using metal organic chemical vapor deposition, hydride vapor epitaxy, molecular beam epitaxy, or the like. In an implementation, before performing the process of forming the third barrier layer 136c, an ashing process or a cleaning process may be performed. In an implementation, the third barrier layer 136c may have a thicker thickness compared to the first barrier layer 136a and the second barrier layer 136b. For example, the third barrier layer 136c may be about 20 nm, but is not limited thereto.

The third barrier layer 136c may include AlGaN. In the implementation, process parameters of deposition equipment may be controlled such that the third barrier layer 136c has a lower content of aluminum (Al) than the content of aluminum in the first barrier layer 136a.

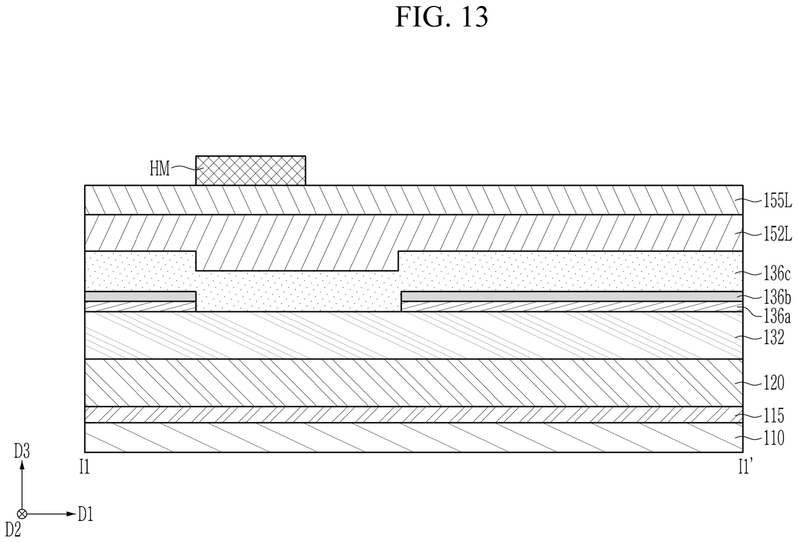

Next, as illustrated in FIG. 13, a gate semiconductor material layer 152L and a gate electrode material layer 155L may be formed on the third barrier layer 136c.

First, the gate semiconductor material layer 152L may be formed to entirely cover the upper surface of the third barrier layer 136c. The process of forming the gate semiconductor material layer 152L may be performed after the third barrier layer 136c is formed, and may be continuously carried out on the third barrier layer 136c by using, for example, metal-organic chemical vapor deposition (MOCVD), hydride vapor phase epitaxy (HVPE), or molecular beam epitaxy (MBE).

Next, a gate electrode material layer 155L may be formed on the gate semiconductor material layer 152L. For example, the gate electrode material layer 155L may be formed using a deposition process. For example, the gate electrode material layer 155L may be formed using, electron beam evaporation (E-beam evaporation), sputtering, physical vapor deposition (PVD), thermal chemical vapor deposition (thermal CVD), low pressure chemical vapor deposition (LP-CVD), plasma enhanced chemical vapor deposition (PE-CVD), or atomic layer deposition (ALD) but is not limited to.

To etch a portion of the gate semiconductor material layer 152L and the gate electrode material layer 155L, a hard mask pattern HM may be formed on the portion of the gate electrode material layer 155L. For example, the hard mask pattern HM may include a spin-on hard mask (SOH) material. Alternatively, the hard mask pattern HM may include silicon oxide, silicon nitride, silicon oxynitride, or a combination thereof. A hard mask layer may be formed on a gate electrode material layer 155L and then patterned to form a hard mask pattern HM.

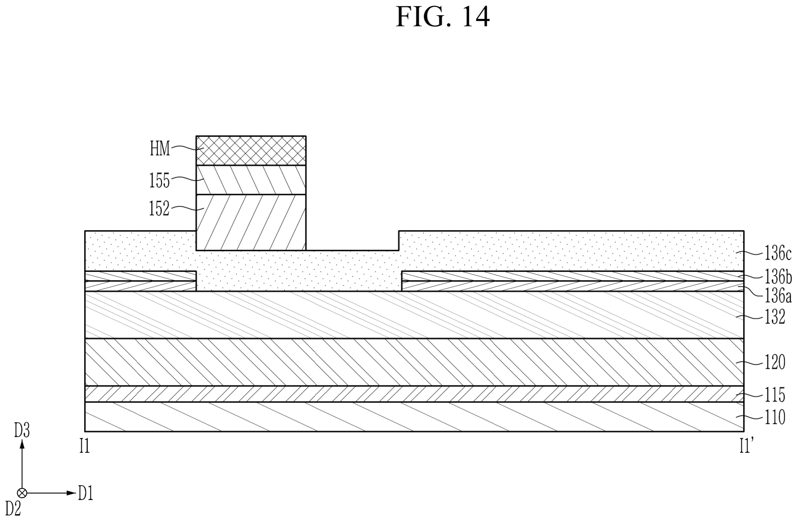

Next, the gate semiconductor material layer 152L and the gate electrode material layer 155L are etched to form the gate semiconductor layer 152 and the gate electrode 155, respectively. As illustrated in FIG. 14, the gate semiconductor material layer 152L and the gate electrode material layer 155L may be patterned using the hard mask pattern HM as a mask to form a gate semiconductor layer 152 and a gate electrode 155, respectively.

In an implementation, the etching of the gate semiconductor material layer 152L and the gate electrode material layer 155L may be performed by dry etching using an etching gas. The etching gas may contain fluoride gas or chloride gas. For example, the fluoride gas may include, for example, CHF3, CF4, or a mixture thereof, and the chloride gas may include, for example, CI2, BCI3, or a mixture thereof.

In some implementations, after etching the portion of the gate semiconductor material layer 152L and the portion of the gate electrode material layer 155L, a process of removing byproducts and cleaning the substrate 110 may be performed. For example, byproduct removal may be accomplished through an ashing or strip process. The ashing process and stripping process may be performed sequentially. For example, an ashing process may be performed first to remove the oxygen (O₂) plasma treatment process or the ozone (O₃) treatment process, and then the stripping process may be performed. Separately from the ashing process or the strip process, a process for cleaning the substrate 110 may be performed. For example, the cleaning process may include a dry cleaning process using, for example, NH3 gas, NF3 gas, or NF3 plasma, or a wet cleaning process using HF or BOE. Afterwards, the substrate 110 may be cleaned using a cleaning solution such as ammonia water (NH4OH). In this process, the hard mask pattern HM remaining on the gate electrode 155 may be removed.

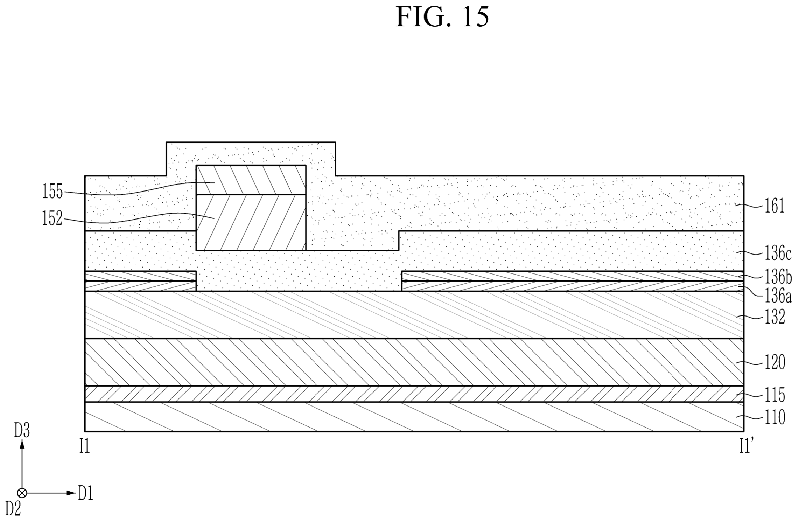

As illustrated in FIG. 15, a first protective layer 161 may be formed on the third barrier layer 136c, the gate semiconductor layer 152, and the gate electrode 155. The first protective layer 161 may be formed using a deposition process. The first protective layer 161 may include an insulating material. For example, the first protective layer 161 may include a material such as SiO₂, SiN, SiON, or Al₂O₃. The first protective layer 161 is depicted as a single layer, but may be formed of multiple layers in some cases. At this time, different materials may be sequentially deposited to form a first protective layer 161. Alternatively, the first protective layer 161 may be formed as multiple layers having different properties by using the same material under different deposition conditions. In particular, the portion of the first protective layer 161 adjacent to the barrier layer 136 may be formed of an insulating material having significantly better quality than other portions. This is to prevent electrons forming a channel from being trapped within the channel layer 132 located below the barrier layer 136. The portion of the first protective layer 161 in contact with the barrier layer 136 may be made of silicon oxide (SiO₂).

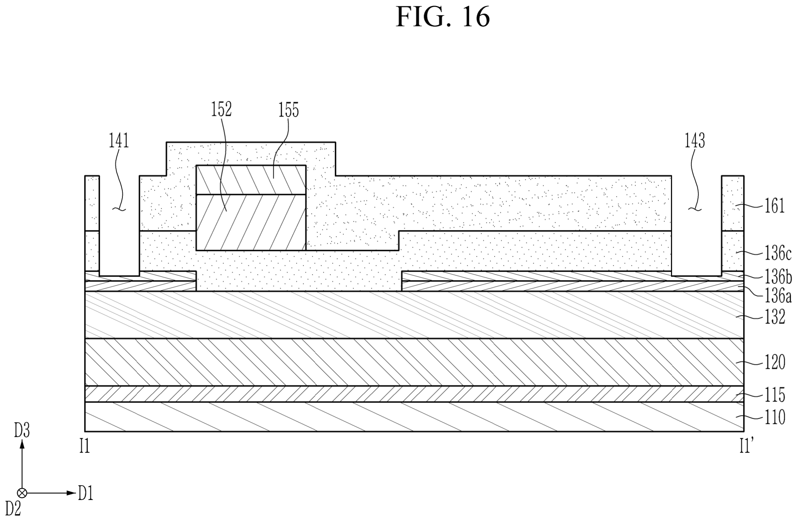

As illustrated in FIG. 16, a first trench 141 and a second trench 143 may be formed by patterning the first protective layer 161 using a photo and etching process. At this time, not only the first protective layer 161, but also a portion of the third barrier layer 136c and a portion of the second barrier layer 136b may be patterned together.

For example, a photoresist pattern may be formed on the first protective layer 161, and the third barrier layer 136c and a portion of the second barrier layer 136b may be sequentially etched using the photoresist pattern as a mask. At this time, the first protective layer 161 and the third barrier layer 136c may be penetrated by the first trench 141 and the second trench 143, and the upper surface of the second barrier layer 136b may be recessed. The second barrier layer 136b may not be penetrated by the first trench 141 or the second trench 143. That is, the depth at which the upper surface of the second barrier layer 136b is recessed may be smaller than the entire thickness of the second barrier layer 136b. The depth at which the upper surface of the second barrier layer 136b is recessed may be varied. The side surfaces of the first protective layer 161 and the third barrier layer 136c may be exposed to the outside by the first trench 141 and the second trench 143, and the upper surface and side surfaces of the second barrier layer 136b may be exposed. The second barrier layer 136b may form the bottom and side walls of the first trench 141 and the second trench 143, and the first protective layer 161 and the third barrier layer 136c may form the side walls of the first trench 141 and the second trench 143.

The first trench 141 and the second trench 143 may be spaced apart from each other. The first trench 141 and the second trench 143 may be located on both sides of the gate electrode 155. The first trench 141 may be positioned on one side of the gate electrode 155 so as to be spaced apart from the gate electrode 155. The second trench 143 may be positioned on the other side of the gate electrode 155 so as to be spaced apart from the gate electrode 155. The distance at which the first trench 141 is spaced from the gate electrode 155 may be smaller than the distance at which the second trench 143 is spaced from the gate electrode 155. The first trench 141 and the second trench 143 are illustrated as having similar widths, depths, and shapes to each other, but are not limited thereto. The shapes of the first trench 141 and the second trench 143 may be changed in various ways.

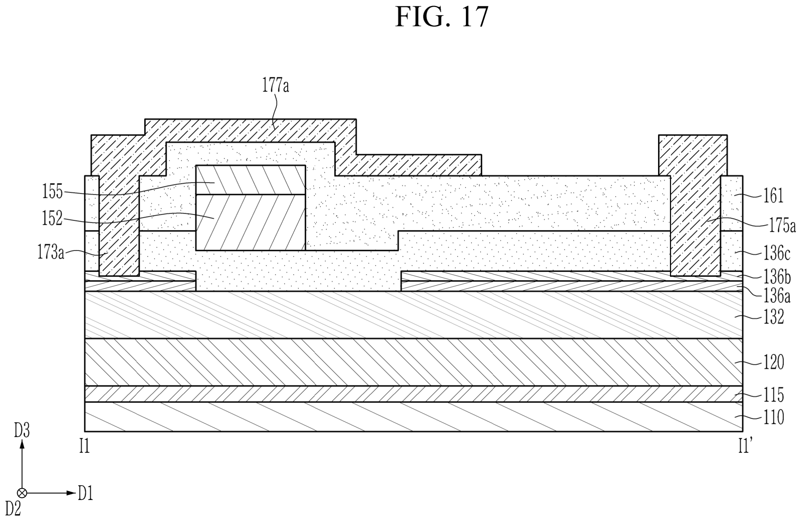

As illustrated in FIG. 17, the interior of the first trench 141 and the second trench 143 may be filled to form a lower source electrode 173a and a lower drain electrode 175a, respectively. At this time, the first field dispersion layer 177a may be formed together.

The lower source electrode 173a may be formed such that it fills the interior of the first trench 141 (see FIG. 16). Within the first trench 141 (see FIG. 16), the lower source electrode 173a may be in contact with the first protective layer 161, the second barrier layer 136b, and the third barrier layer 136c. The lower source electrode 173a may be in contact with the side surfaces of the first protective layer 161 and the second barrier layer 136b. The lower source electrode 173a may cover the side surfaces of the first protective layer 161 and the third barrier layer 136c. The lower source electrode 173a may be electrically connected to the second barrier layer 136b through the first trench 141.

The lower drain electrode 175a may be formed such that it fills the interior of the second trench 143 (see FIG. 16). Within the second trench 143 (see FIG. 16), the lower drain electrode 175a may be in contact with the first protective layer 161, the second barrier layer 136b, and the third barrier layer 136c. The lower drain electrode 175a may be in contact with the side surfaces of the first protective layer 161 and the third barrier layer 136c. The lower drain electrode 175a may cover the side surfaces of the first protective layer 161 and the third barrier layer 136c. The lower drain electrode 175a may be electrically connected to the second barrier layer 136b through the second trench 143. The upper surface of the lower drain electrode 175a may protrude above the upper surface of the first protective layer 161.

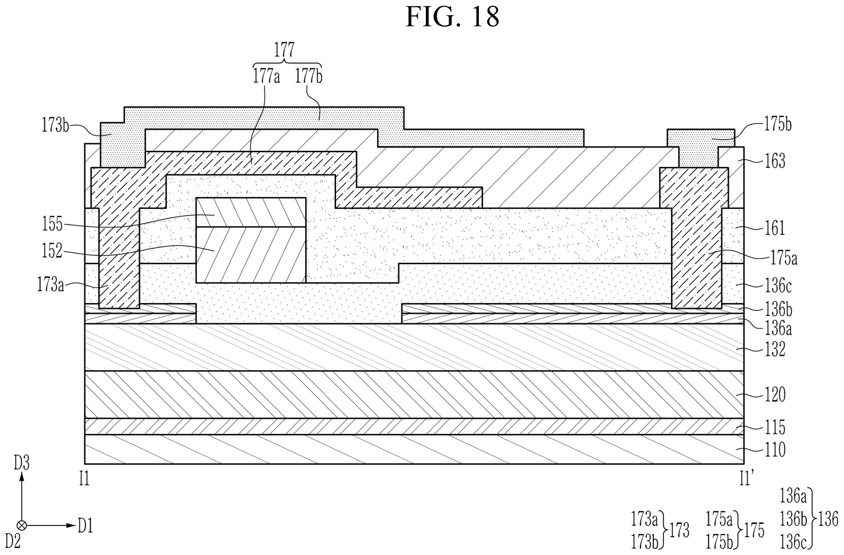

As illustrated in FIG. 18, the second protective layer 163 may be formed on the first protective layer 161, a portion of the second protective layer 163 may be etched and removed, and then the removed portion may be filled with a conductive material to form the upper source electrode 173b and the upper drain electrode 175b. At this time, a second field dispersion layer 177b may be formed together.

Although the implementations of the present disclosure have been described in detail above, the scope of the present disclosure is not limited thereto, and various modifications and improvements made by those skilled in the art within the scope of the present disclosure as set out in the appended claims.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

Embodiments are set out in the following clauses:
1. A semiconductor device comprising:
   a substrate;
   a channel layer on the substrate;
   a first barrier layer on the channel layer;
   a second barrier layer on the first barrier layer;
   a third barrier layer on the second barrier layer and extending into a portion of the first barrier layer and a portion of the second barrier layer;
   a gate electrode on the third barrier layer; and
   a source electrode and a drain electrode on respective sides of the gate electrode,
   wherein each of the source electrode and the drain electrode extends into a first portion of the third barrier layer and is connected to the second barrier layer, and
   wherein the second barrier layer is doped with silicon.
2. The semiconductor device of clause 1, wherein:
   the gate electrode overlaps, in a thickness direction, a second portion of the third barrier layer that extends into the first and second barrier layers, and
   the first barrier layer and the second barrier layer are spaced apart from the gate electrode in the thickness direction.
3. The semiconductor device of clause 1 or clause 2, wherein:
   a thickness of each of the first barrier layer and second barrier layer is smaller than a thickness of the third barrier layer.
4. The semiconductor device of any preceding clause, wherein:
   a thickness of each of the first barrier layer and second barrier layer is greater than 0 nm and less than or equal to 2 nm.
5. The semiconductor device of any preceding clause, wherein:
   the first barrier layer, the second barrier layer, and the third barrier layer include aluminum gallium nitride (AlGaN), and
   a content of aluminum in the first barrier layer is greater than a content of aluminum in the third barrier layer.
6. The semiconductor device of clause 5, wherein:
   a content of aluminum in the second barrier layer is greater than or equal to the content of aluminum in the third barrier layer.
7. The semiconductor device of any preceding clause, wherein:
   the first barrier layer includes AlGaN, and
   a content of aluminum in the first barrier layer is greater than or equal to 10 at% and less than or equal to 30 at%.
8. The semiconductor device of any preceding clause, wherein:
   a doping concentration of silicon in the second barrier layer is greater than or equal to 1.0×10¹⁷ cm⁻³ and less than or equal to 1.0×10²⁰ cm⁻³.
9. The semiconductor device of clause 5 or any clause dependent thereon, comprising:
   a two-dimensional electron gas in the channel layer,
   wherein the channel layer includes a first region having an upper surface contacting the third barrier layer and a second region having an upper surface contacting the first barrier layer, and
   wherein a density of the two-dimensional electron gas in the second region is greater than a density of the two-dimensional electron gas in the first region.
10. The semiconductor device of clause 9, comprising:
   a fourth barrier layer between the gate electrode and the drain electrode, the fourth barrier layer being at a same level as the first barrier layer and in contact with at least a portion of a side surface of the first barrier layer,
   wherein the fourth barrier layer includes AlGaN, and
   wherein a content of aluminum in the fourth barrier layer is less than the content of aluminum in the first barrier layer.
11. The semiconductor device of clause 10, wherein:
   the content of aluminum in the fourth barrier layer is greater than the content of aluminum in the third barrier layer.
12. The semiconductor device of clause 10 or clause 11, wherein the channel layer includes a third region having an upper surface contacting the fourth barrier layer, and
   wherein a density of the two-dimensional electron gas in the third region is greater than the density of the two-dimensional electron gas in the first region and less than the density of the two-dimensional electron gas in the second region.
13. The semiconductor device of any of clauses 10 to 12, wherein:
   a thickness of the fourth barrier layer is greater than a thickness of the first barrier layer, and the fourth barrier layer is in contact with at least a portion of a side surface of the second barrier layer.
14. The semiconductor device of any preceding clause, wherein:
   the channel layer includes a first portion having an upper surface contacting the first barrier layer and a second portion having an upper surface contacting the third barrier layer, and
   wherein, on the second portion, the third barrier layer includes a first part having a first thickness and a second part having a second thickness that is greater than the first thickness.
15. The semiconductor device of clause 14, comprising:
   a two-dimensional electron gas in the channel layer,
   wherein the channel layer includes a fourth region having an upper surface contacting the first part, a fifth region having an upper surface contacting the second part, and a sixth region having an upper surface contacting the first barrier layer,
   wherein the first portion comprises the sixth region, and the second portion comprises the fourth and fifth regions, and
   wherein a density of the two-dimensional electron gas in the fifth region is greater than a density of the two-dimensional electron gas in the fourth region and less than a density of the two-dimensional electron gas in the sixth region.
16. A semiconductor device comprising:
   a substrate;
   a channel layer on the substrate;
   a first barrier layer on the channel layer;
   a second barrier layer on the first barrier layer;
   a third barrier layer on the second barrier layer and extending into a portion of the first barrier layer and a portion of the second barrier layer;
   a gate electrode on the third barrier layer; and
   a source electrode and a drain electrode positioned on respective sides of the gate electrode,
   wherein each of the source electrode and the drain electrode extends into a portion of the third barrier layer and is connected to the second barrier layer,
   wherein the first, second, and third barrier layers include aluminum gallium nitride (AlGaN), and
   wherein a content of aluminum in the first barrier layer is greater than a content of aluminum in the third barrier layer.
17. The semiconductor device of clause 16, comprising:
   a two-dimensional electron gas in the channel layer,
   wherein the channel layer includes a first region having an upper surface contacting the third barrier layer and a second region having an upper surface contacting the first barrier layer, and
   wherein a density of the two-dimensional electron gas in the second region is greater than a density of the two-dimensional electron gas in the first region.
18. The semiconductor device of clause 16 or clause 17, wherein:
   a content of aluminum in the second barrier layer is greater than or equal to the content of aluminum in the third barrier layer.
19. The semiconductor device of any of clauses 16 to 18, wherein:
   the second barrier layer is doped with silicon.
20. A semiconductor device comprising:
   a substrate;
   a buffer layer on the substrate;
   a channel layer on the buffer layer;
   a first barrier layer on the channel layer;
   a second barrier layer on the first barrier layer;
   a third barrier layer on the second barrier layer, the third barrier layer have a first portion that extends into a portion of the first barrier layer and a portion of the second barrier layer;
   a gate electrode on the first portion of the third barrier layer, the gate electrode extending in a first direction parallel to a surface of the substrate;
   a gate semiconductor layer between the first to three barrier layers and the gate electrode, the gate semiconductor layer having the same width in a horizontal direction as the gate electrode, and the gate semiconductor layer extending in the first direction;
   a first protective layer covering the third barrier layer, the gate electrode, and the gate semiconductor layer; and
   a source electrode and a drain electrode on respective sides of the gate electrode, the source electrode and the drain electrode extending into the first protective layer and a second portion of the third barrier layer, the source electrode and the drain electrode being connected to the second barrier layer,
   wherein the second barrier layer is doped with silicon.

## Claims

1. A semiconductor device comprising:
a substrate (110);
a channel layer (132) on the substrate (110);
a first barrier layer (136a) on the channel layer (132);
a second barrier layer (136b) on the first barrier layer (136a);
a third barrier layer (136c) on the second barrier layer (136b) and extending into a portion of the first barrier layer (136a) and a portion of the second barrier layer (136b);
a gate electrode (155) on the third barrier layer (136c); and
a source electrode (173) and a drain electrode (175) on respective sides of the gate electrode (155),
wherein each of the source electrode (173) and the drain electrode (175) extends into a first portion of the third barrier layer (136a) and is connected to the second barrier layer (136b), and
wherein the second barrier layer (136b) is doped with silicon.

2. The semiconductor device of claim 1, wherein:
the gate electrode (155) overlaps, in a thickness direction, a second portion of the third barrier layer (136c) that extends into the first and second barrier layers (136a,b), and
the first barrier layer (136a) and the second barrier layer (136b) do not overlap with the gate electrode (155) in the thickness direction.

3. The semiconductor device of claim 1 or claim 2, wherein:
a thickness of each of the first barrier layer (136a) and second barrier layer (136b) is smaller than a thickness of the third barrier layer (136c).

4. The semiconductor device of any preceding claim, wherein:
a thickness of each of the first barrier layer (136a) and second barrier layer (136b) is greater than 0 nm and less than or equal to 2 nm.

5. The semiconductor device of any preceding claim, wherein:
the first barrier layer (136a), the second barrier layer (136b), and the third barrier layer (136c) include aluminum gallium nitride (AlGaN), and
a content of aluminum in the first barrier layer (136a) is greater than a content of aluminum in the third barrier layer (136c).

6. The semiconductor device of claim 5, wherein:
a content of aluminum in the second barrier layer (136b) is greater than or equal to the content of aluminum in the third barrier layer (136c).

7. The semiconductor device of any preceding claim, wherein:
the first barrier layer (136a) includes AlGaN, and
a content of aluminum in the first barrier layer (136a) is greater than or equal to 10 at% and less than or equal to 30 at%.

8. The semiconductor device of any preceding claim, wherein:
a doping concentration of silicon in the second barrier layer (136b) is greater than or equal to 1.0×10¹⁷ cm⁻³ and less than or equal to 1.0×10²⁰ cm⁻³.

9. The semiconductor device of claim 5 or any claim dependent thereon, comprising:
a two-dimensional electron gas (134) in the channel layer (132),
wherein the channel layer (132) includes a first region having an upper surface contacting the third barrier layer (136c) and a second region having an upper surface contacting the first barrier layer (136a), and
wherein a density of the two-dimensional electron gas (134) in the second region is greater than a density of the two-dimensional electron gas (134) in the first region.

10. The semiconductor device of claim 9, comprising:
a fourth barrier layer (136d) between the gate electrode (155) and the drain electrode (175), the fourth barrier layer (136d) being at a same level as the first barrier layer (136a) and in contact with at least a portion of a side surface of the first barrier layer (136a),
wherein the fourth barrier layer (136d) includes AlGaN, and
wherein a content of aluminum in the fourth barrier layer (136d) is less than the content of aluminum in the first barrier layer (136a).

11. The semiconductor device of claim 10, wherein:
the content of aluminum in the fourth barrier layer (136d) is greater than the content of aluminum in the third barrier layer (136c).

12. The semiconductor device of claim 10 or claim 11, wherein the channel layer (132) includes a third region having an upper surface contacting the fourth barrier layer (136d), and
wherein a density of the two-dimensional electron gas (134) in the third region is greater than the density of the two-dimensional electron gas (134) in the first region and less than the density of the two-dimensional electron gas (134) in the second region.

13. The semiconductor device of any of claims 10 to 12, wherein:
a thickness of the fourth barrier layer (136d) is greater than a thickness of the first barrier layer (136a), and the fourth barrier layer (136d) is in contact with at least a portion of a side surface of the second barrier layer (136b).

14. The semiconductor device of any preceding claim, wherein:
the channel layer (132) includes a first portion having an upper surface contacting the first barrier layer (136a) and a second portion having an upper surface contacting the third barrier layer (136c), and
wherein, on the second portion, the third barrier layer (136c) includes a first part having a first thickness and a second part having a second thickness that is greater than the first thickness.

15. The semiconductor device of claim 14, comprising:
a two-dimensional electron gas (134) in the channel layer (132),
wherein the channel layer (132) includes a fourth region having an upper surface contacting the first part, a fifth region having an upper surface contacting the second part, and a sixth region having an upper surface contacting the first barrier layer (136a),
wherein the first portion comprises the sixth region, and the second portion comprises the fourth and fifth regions, and
wherein a density of the two-dimensional electron gas (134) in the fifth region is greater than a density of the two-dimensional electron gas (134) in the fourth region and less than a density of the two-dimensional electron gas (134) in the sixth region.
